# EUROPÄISCHE PATENTSCHRIFT

(11) **EP 3 997 466 B1**
(45) Veröffentlichungstag und Bekanntmachung des Hinweises auf die Patenterteilung: **08.05.2024**
(21) Anmeldenummer: 20733716.3
(22) Anmeldetag: 15.06.2020
(51) Int. Cl.: G01R 19/00, G01R 1/20

(54) **VORRICHTUNG ZUR STROM- UND SPANNUNGSMESSUNG EINES EINGANGSSIGNALS**
DEVICE FOR MEASURING THE CURRENT AND VOLTAGE OF AN INPUT SIGNAL
DISPOSITIF DE MESURE DU COURANT ET DE LA TENSION D'UN SIGNAL D'ENTRÉE

(30) Priorität: 16.07.2019 DE 102019119235
(43) Veröffentlichungstag der Anmeldung: 18.05.2022
(73) Patentinhaber: Liebherr-Elektronik GmbH, 88131 Lindau (DE)
(72) Erfinder: KLAUCK, Thomas, 88145 Hergatz (DE); BRASCH, Marcel, 88364 Wolfegg (DE)
(74) Vertreter: Laufhütte, Dieter
(86) Internationale Anmeldenummer: PCT/EP2020/066425
(87) Internationale Veröffentlichungsnummer: WO 2021/008789

(56) Entgegenhaltungen:
- EP-A2- 1 340 092
- WO-A1-2015/001412

## Beschreibung

Die vorliegende Erfindung betrifft eine Vorrichtung zur Strom- und Spannungsmessung eines Eingangssignals sowie ein Verfahren zum Durchführen einer solchen Messung an der genannten Vorrichtung.

Insbesondere im Bereich von mobilen Arbeitsmaschinen ist es oftmals erforderlich, dass Steuergeräte dazu in der Lage sind, den Strom oder die Spannung eines Signals zu bestimmen.

Nach dem Stand der Technik wird dieses analoge Signal typischerweise dupliziert und an zwei unterschiedliche Eingänge des Steuergeräts gegeben, so dass an einem dieser Eingänge mit einer spezifischen Schaltung die Spannung und an dem anderen Eingang mit Hilfe einer anderen Schaltung der Strom bestimmt wird. Insbesondere wenn es um sicherheitsrelevante Signale geht, hat die Funktion der Strom- oder Spannungsbestimmung einen hohen Stellenwert und trägt einen maßgeblichen Beitrag dazu bei, um ein hohes Niveau in Bezug auf die funktionale Sicherheit zu erreichen.

Aus der WO 2015/001412 A1 und der EP 1 340 092 A2 sind Vorrichtungen zur Strom- und Spannungsmessung eines Eingangssignals bekannt.

Bei der aus dem Stand der Technik bekannten Umsetzung ist es jedoch nachteilhaft, dass zur Bestimmung von Strom und Spannung verschiedene, voneinander getrennte Schaltungen erforderlich sind, so dass bei hohen Anforderungen an einen zu minimierenden Einbauraum und der Reduzierung von Steckerverbindungen (oder auch Pin-Verbindungen) diese nicht erfüllt werden können.

Es ist demnach das Ziel der vorliegenden Erfindung die oben aufgeführten Nachteile abzumildern oder zu überwinden und eine Vorrichtung zu schaffen, die bei Beibehaltung des üblichen Sicherheits- und Ausfallniveaus weniger Steckerverbindungen (oder auch Pin-Verbindungen) erfordert und somit auch in kompakterer Form zur Verfügung steht.

Dies gelingt mit einer Vorrichtung, die sämtliche Merkmale des Anspruchs 1 aufweist. Weitere vorteilhafte Ausgestaltungen sind in den abhängigen Ansprüchen gegeben. Ein bevorzugtes Verfahren zum Betätigen der Vorrichtung ist in den Ansprüchen 7 bis 11 dargestellt.

Die erfindungsgemäße Vorrichtung zur Strom- und Spannungsmessung eines Eingangssignals umfasst einen ersten Anschluss zum Verbinden mit einer Versorgungsspannung, eine Eingangsleitung zum Verbinden mit dem zu messenden Eingangssignal, einen ersten Widerstand, der mit einem seiner Enden von der Eingangsleitung abgeht und mit seinem anderen Ende mit einem ersten Schalter verbunden ist, der in einem geschlossenen Zustand den ersten Anschluss direkt mit dem ersten Widerstand verbindet, einen zweiten Widerstand, der mit einem seiner Enden von der Eingangsleitung abgeht und mit seinem anderen Ende mit einem zweiten Schalter verbunden ist, der in einem geschlossenen Zustand die Erde direkt mit dem zweiten Widerstand verbindet, einen dritten Widerstand, der mit einem seiner Enden von der Eingangsleitung abgeht und mit seinem anderen Ende direkt mit der Erde in Verbindung steht, und einen von der Eingangsleitung abgehenden Signalabgriff zum Bestimmen eines Strom- und/oder Spannungsmesswerts.

Dadurch ist es möglich, das an der Eingangsleitung anliegende Eingangssignal einer unabhängigen und sicherheitsrelevanten Auswertung zu unterziehen, wobei dies mit nur einem Messsignal geschieht. In anderen Worten ist es also nicht mehr länger erforderlich, dass -wie im Stand der Technik üblich- das Eingangssignal dupliziert und zwei unterschiedlichen Schaltkreisen zugeführt wird.

Weiter ist es durch das wahlweise Schließen des zweiten Schalters möglich, eine individuelle Auswertung des Eingangssignals auf Grundlage einer Strom- oder Spannungsmessung durchzuführen.

Die beanspruchte Vorrichtung stellt daher die Funktionsweise bis Performance Level "d" nach ISO-13849 gemäß Kategorie 2 für eine Schnittstelle mit kombinierter Strom- und Spannungsmessung sicher.

Es ist mit der Vorrichtung demnach möglich, mit Hilfe des ersten und des zweiten Schalters, die vorzugsweise mittels eines Steuergeräts steuerbar sind, das verwendete Messverfahren zur Analyse des auf der Eingangsleitung befindlichen Signals zu wählen (Strom oder Spannung), wobei das zu analysierende Signal gleichzeitig über den Eingangskanal eingelesen und dabei überwacht und diagnostiziert werden kann.

Nach einer Fortbildung der Erfindung ist vorgesehen, dass der zweite Widerstand ein Widerstand mit Mittelabgriff ist, von dem ein Überwachungsabgriff zum Bestimmen eines Strom- und/oder Spannungsmesswerts abgeht.

Dabei kann der Mittelabgriff variabel an dem Widerstand, nach Art eines einstellbaren Potentiometers angeordnet sein oder aber mit einem festen Verhältnis zum Widerstand daran befestigt sein.

Nach einer optionalen Modifikation der Erfindung ist vorgesehen, dass der Überwachungsabgriff dazu ausgelegt ist, einen Strom- und/oder Spannungsmesswert über einen zu dem Signalabgriff zweiten dissimilaren Kanal zu ermöglichen.

Durch das Abgreifen des Strom- oder Spannungsmesswerts auch über den Überwachungsabgriff liegt eine redundante Messung vor, die das Auftreten von falsch gemessenen Werten reduziert. Eine Auswertung über die dissimilaren und zueinander redundanten Werte erfordert nach der vorliegenden Erfindung dennoch aber nur das Vorhandensein von einer gemeinsamen Schaltung.

Vorzugsweise ist vorgesehen, dass der Signalabgriff und vorzugsweise auch der Überwachungsabgriff über einen jeweiligen Widerstand verfügt über den das abzugreifende Signal geführt wird.

Weiter kann nach der Erfindung vorgesehen sein, eine Steuereinheit zu implementieren, die dazu ausgelegt ist, den ersten Schalter und/oder den zweiten Schalter zu betätigen, um in Abhängigkeit einer Schaltstellung des ersten Schalters und/oder des zweiten Schalters eine Strom- und/oder Spannungsmessung des Eingangssignals durchzuführen bzw. das Vorhandensein einer Strom- oder Spannungsquelle am Eingangssignal zu erfassen.

So wird durch Schließen des zweiten Schalters ein Stromfluss durch den zweiten Widerstand erzwungen, der durch den Überwachungsabgriff mittels eines Spannungsabfalls erfasst werden kann und aufgrund des bekannten Widerstandswerts in einen Strom überführbar ist.

Vorzugsweise ist dabei die Steuereinheit mit dem Signalabgriff und/oder mit dem Überwachungsabgriff verbunden, um eine Auswertung der empfangenen Signale vorzunehmen.

Erfindungsgemäß ist vorgesehen, dass diese ferner ein den ersten Anschluss und die Eingangsleitung verbindenden dritten Schalter zum Überbrücken des ersten Widerstands und des ersten Schalters umfasst, um die Funktionsfähigkeit des ersten Widerstands zu überprüfen.

Überbrückt man mit Hilfe des dritten Schalters den ersten Widerstand, so ändert sich das Spannungsniveau an dem Signalabgriff bzw. dem dazu redundanten Überwachungsabgriff entsprechend. Öffnet man den dritten Schalter hingegen, so teilt sich die Versorgungsspannung entsprechend dem Widerstandsverhältnis der hin zur Erde in Reihe geschalteten Widerstände auf, so dass man von funktionsfähigen Widerständen ausgehen kann.

Erfindungsgemäß ist ferner ein die Eingangsleitung und die Erde verbindender vierter Schalter zum Überbrücken des dritten Widerstands vorgesehen, um die Funktionsfähigkeit des dritten Widerstands zu überprüfen.

Das Prinzip zur Prüfung der Funktionalität des dritten Widerstands entspricht dabei dem oben bereits vorgestellten Vorgehen, so dass an dieser Stelle hierauf verwiesen werden kann.

Von Vorteil ist hierbei, dass der dritte und/oder auch der vierte Schalter durch die Steuereinheit betätigbar sind, so dass die Vorrichtung auf ihre Funktionsfähigkeit hin überprüfbar und auch diagnostizierbar ist.

Die Erfindung betrifft zudem ein Verfahren zur Strom- und/oder Spannungsmessung eines Eingangssignals mit einer Vorrichtung nach einem der vorhergehenden Ansprüche, wobei in dem Verfahren durch Schließen des ersten Schalters überprüft wird, ob das Eingangssignal mit einer Spannungs- oder Stromquelle verbunden ist oder nicht, und dann, wenn das Eingangssignal nicht mit einer Spannungs- oder Stromquelle verbunden ist, sich aus den Verhältnissen von dem ersten Widerstand und dem zweiten Widerstand ein definierter Spannungs- bzw. Stromwert an dem Signalabgriff ergibt.

Zudem kann nach dem Verfahren weiter vorgesehen sein, dass wenn das Eingangssignal mit einer Spannungs- oder Stromquelle verbunden ist, dieses Signal mittels des zweiten Widerstands und des dritten Widerstands am Signalabgriff und/oder am Überwachungsabgriff gemessen wird, wobei vorzugsweise hierfür auch auf den ersten Widerstand zurückgegriffen wird.

Dabei kann vorzugsweise der zweite Schalter geschlossen sein.

In dem Verfahren ist nach der Erfindung ferner möglich, dass bei geöffnetem zweiten Schalter anhand des Spannungsabfalls über den dritten Widerstand gemessen wird, wie hoch die Spannung des Eingangssignals ist.

Weiter kann vorgesehen sein, dass in dem Verfahren ferner bei geschlossenem zweiten Schalter anhand des Spannungsabfalls über den zweiten Widerstand, der vorzugsweise ein Widerstand mit Mittelabgriff für den Überwachungsabgriff ist, bestimmt wird, wie hoch die Stromstärke des Eingangssignals ist.

Darüber hinaus wird nach der Erfindung durch das Schließen eines den ersten Widerstand und den ersten Schalter überbrückenden Schalters geprüft, ob der erste Widerstand fehlerfrei arbeitet, wobei zusätzlich oder alternativ dazu in analoger Weise durch das Schließen eines den dritten Widerstand überbrückenden Schalters geprüft werden kann, ob der dritte Widerstand fehlerfrei arbeitet.

Weitere Merkmale, Einzelheiten und Vorteile der vorliegenden Erfindung werden anhand der nachfolgenden Figurenbeschreibung ersichtlich. Dabei zeigt:

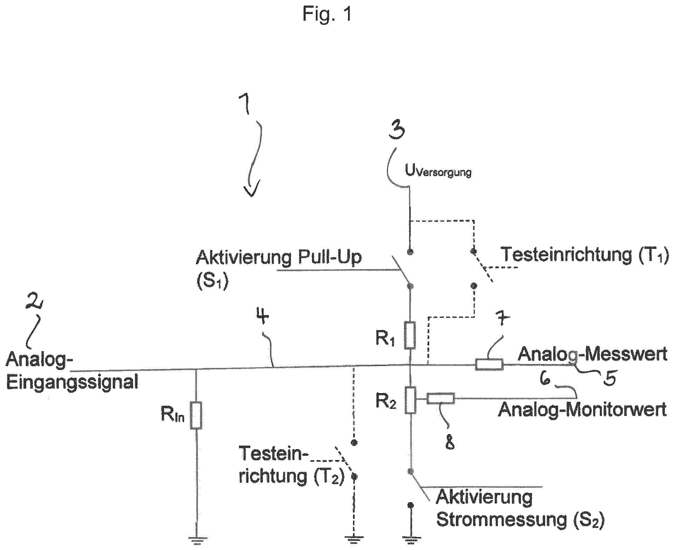

- Fig. 1: ein schematisches Schaltbild der vorliegenden Erfindung.

Fig. 1 zeigt die erfindungsgemäße Vorrichtung 1. Man erkennt die Eingangsleitung 4, auf die das Eingangssignal 2, dessen Strom- und/oder Spannungswert gemessen werden kann, gegeben wird. Dabei handelt es sich in der Regel um ein analoges Signal.

Von der Eingangsleitung 4 geht ein erster Widerstand R₁ ab, der über einen Schalter S₁, dem sogenannten Pull-Up-Schalter, mit einer Versorgungsspannung U_{Versorgung} verbindbar ist. Zudem gehen von der Eingangsleitung 4 zwei weitere Widerstände parallel zueinander ab, wobei einer davon, nämlich der zweite Widerstand R₂ nicht direkt mit Erde verbunden ist, sondern nur bei einem geschlossenen Schalter S₂ mit Erde verbunden ist. Dieser Schalter S₂ dient dazu, die Strommessung des auf die Eingangsleitung 4 gegebenen Eingangssignals 2 zu aktivieren. Für die Funktionalität der Erfindung ist es unerheblich, ob die oben beschriebenen Schalter auf der zur Eingangsleitung 4 abgewandten Seite des zugehörigen Widerstands R₁, R₂ oder auf der zur Eingangsleitung 4 zugewandten Seite des zugehörigen Widerstands R₁, R₂ angeordnet sind.

Der dritte Widerstand R_{In}, der parallel zum zweiten Widerstand R₂ angeordnet ist, ist dabei fest mit Erde verbunden.

Darüber hinaus ist ein Signalabgriff 5 und ein Überwachungsabgriff 6 vorgesehen, an dem Signale zum Messen von Strom und/oder Spannung abgenommen werden. Diese werden typischerweise in eine Steuereinheit (nicht dargestellt) überführt, wo diese entsprechend ausgewertet werden.

Weiter sind die Schalter S₁ und S₂ typischerweise auch durch eine Steuereinheit betätigbar, so dass die zugehörigen Widerstände R₁, R₂ je nach Anwendungsfall zuschaltbar sind.

So kann mit Hilfe des Schalters S1 der vorhandene elektrische Widerstand R1 zugeschaltet werden, so dass über die Versorgungsspannung U_{Versorgung} ein definierter Pegel an den beiden Ausgängen Signalabgriff 5 (auch bezeichnet mit: Analog Messwert) und Überwachungsabgriff 6 (auch bezeichnet mit: Analog-Monitorwert) anliegt.

Sofern nun das Eingangssignal 2 nicht mit einer Spannungs- oder Stromquelle verbunden ist (open-load-Zustand), ergibt sich aus den Verhältnissen von R₁ und R₂ ein definierter Spannungs- bzw. Stromwert.

Ist hingegen eine Spannungs- oder Stromquelle an der Eingangsleitung 4 angeschlossen, so kann dieses Eingangssignal 2 mit Hilfe der Schaltung gemessen werden, welche R_{In} und R₂, ggf. auch R₁ umfasst oder nur diese Widerstände beinhaltet.

Durch den zusätzlich zum Signalabgriff 5 vorgesehenen Überwachungsabgriff 6 am zweiten Widerstand R₂ kann das Eingangssignal 2 über einen zweiten dissimilaren Kanal ausgewertet werden, so dass die Messung redundant durchgeführt werden kann. Dabei stellt der zweite Wiederstand R₂ einen Serienwiderstand mit Mittelabgriff dar, der über einen Längswiderstand 8 dem Überwachungsabgriff 6 zugeführt wird.

Weiter ist auch der Signalabgriff 5 mit einem Widerstand 7 versehen, um das zu messende Signalniveau auf der Eingangsleitung 4 beim Abgreifen nicht unnötig zu stören.

Die nur gestrichelt eingezeichneten Testeinrichtungen T₁ und T₂ dienen dazu, die für die Erfindung wichtigen Elemente R₁ und R_{In} auf ihre Funktionsfähigkeit hin zu überprüfen. Die Testeinrichtungen T₁ und T₂ sind dabei durch Schalter verkörpert, die den jeweiligen in seiner Funktionsfähigkeit zu überprüfenden Widerstand überbrücken. Durch Schließen des jeweiligen Schalters T₁ oder T₂ verändert sich der durch den Signalabgriff 5 bzw. den Überwachungsabgriff 6 erfasste Wert auf eine vorbestimme Art und Weise gegenüber einem geschlossenen Zustand der Testeinrichtung T₁ oder T₂. Das Überprüfen der Funktionsfähigkeit der zugehörigen Widerstände kann dabei vor der Verwendung der Schaltung oder auch im laufenden Betrieb erfolgen. Durch das Vorsehen der Testeinrichtungen wird die Vorrichtung test- und überwachbar.

Die mit der vorliegenden Erfindung erreichbaren Vorteile liegen vor allem darin, dass nun mit nur einem Eingang, auf den das Eingangssignal 2 gegeben wird, sowohl eine Strom- als auch eine Spannungsmessung möglich ist, wohingegen im Stand der Technik hierfür zwei getrennte Schaltungen verwendet worden sind. So lässt sich durch die Erfindung die durch die Vorrichtung zu belegende Pin-Anzahl reduzieren, was insgesamt eine Verkleinerung der Anschlüsse und der gesamten Vorrichtung erlaubt.

## Patentansprüche

1. Vorrichtung (1) zur Strom- und Spannungsmessung eines Eingangssignals (2), umfassend:
einen ersten Anschluss (3) zum Verbinden mit einer Versorgungsspannung (U_{Versorgung}),
eine Eingangsleitung (4) zum Verbinden mit dem zu messenden Eingangssignal (2),
einen ersten Widerstand (R₁), der mit einem seiner Enden von der Eingangsleitung (4) abgeht und mit seinem anderen Ende mit einem ersten Schalter (S₁) verbunden ist, der in einem geschlossenen Zustand den ersten Anschluss (3) direkt mit dem ersten Widerstand (R₁) verbindet,
einen zweiten Widerstand (R₂), der mit einem seiner Enden von der Eingangsleitung (4) abgeht und mit seinem anderen Ende mit einem zweiten Schalter (S₂) verbunden ist, der in einem geschlossenen Zustand die Erde direkt mit dem zweiten Widerstand (R₂) verbindet,
einen dritten Widerstand (R_{In}), der mit einem seiner Enden von der Eingangsleitung (4) abgeht und mit seinem anderen Ende direkt mit der Erde in Verbindung steht, und
einen von der Eingangsleitung (4) abgehenden Signalabgriff (5) zum Bestimmen eines Strom- und/oder Spannungsmesswerts, wobei ferner
ein den ersten Anschluss (3) und die Eingangsleitung (4) verbindender dritter Schalter (T1) zum Überbrücken des ersten Widerstands (R1) und des ersten Schalters (S1) vorgesehen ist, um die Funktionsfähigkeit des ersten Widerstands (R1) zu überprüfen, und/oder
ein die Eingangsleitung (4) und die Erde verbindender vierter Schalter (T2) zum Überbrücken des dritten Widerstands (RIn) vorgesehen ist, um die Funktionsfähigkeit des dritten Widerstands (RIn) zu überprüfen.

2. Vorrichtung (1) nach Anspruch 1, wobei der zweite Widerstand (R₂) ein Widerstand mit Mittelabgriff ist, von dem ein Überwachungsabgriff (6) zum Bestimmen eines Strom- und/oder Spannungsmesswerts abgeht.

3. Vorrichtung (1) nach Anspruch 2, wobei der Überwachungsabgriff (6) dazu ausgelegt ist, einen Strom- und/oder Spannungsmesswert über einen zu dem Signalabgriff (5) zweiten dissimilaren Kanal zu ermöglichen.

4. Vorrichtung (1) nach einem der vorhergehenden Ansprüche, wobei der Signalabgriff (5) und vorzugsweise auch der Überwachungsabgriff (6) nach Anspruch 2 oder 3 über einen jeweiligen Widerstand (7, 8) verfügt über den das abzugreifende Signal geführt wird.

5. Vorrichtung (1) nach einem der vorhergehenden Ansprüche, wobei eine Steuereinheit vorgesehen ist, die dazu ausgelegt ist, den ersten Schalter (S₁) und/oder den zweiten Schalter (S₂) zu betätigen, um in Abhängigkeit einer Schaltstellung des ersten Schalters (S₁) und/oder des zweiten Schalters (S₂) eine Strom- und/oder Spannungsmessung des Eingangssignals (2) durchzuführen bzw. das Vorhandensein einer Strom- oder Spannungsquelle am Eingangssignal (2) zu erfassen.

6. Vorrichtung (1) nach Anspruch 5, wobei die Steuereinheit mit dem Signalabgriff (5) und vorzugsweise auch mit dem Überwachungsabgriff (6) nach Anspruch 2 oder 3 verbunden ist, um eine Auswertung der empfangenen Signale vorzunehmen.

7. Verfahren zur Strom- und/oder Spannungsmessung eines Eingangssignals (2) mit einer Vorrichtung (1) nach einem der vorhergehenden Ansprüche, wobei in dem Verfahren:
durch Schließen des ersten Schalters (S₁) überprüft wird, ob das Eingangssignal (2) mit einer Spannungs- oder Stromquelle verbunden ist oder nicht, wobei
wenn das Eingangssignal (2) nicht mit einer Spannungs- oder Stromquelle verbunden ist, sich aus den Verhältnissen von dem ersten Widerstand (R₁) und dem zweiten Widerstand (R₂) ein definierter Spannungs- bzw. Stromwert an dem Signalabgriff (5) ergibt, wobei
durch das Schließen eines den ersten Widerstand (R1) und den ersten Schalter (S1) überbrückenden Schalters (T1) geprüft wird, ob der erste Widerstand (R1) fehlerfrei arbeitet, und/oder
durch das Schließen eines den dritten Widerstand (RIn) überbrückenden Schalters (T2) geprüft wird, ob der dritte Widerstand (RIn) fehlerfrei arbeitet.

8. Verfahren nach Anspruch 7, wobei dann, wenn das Eingangssignal (2) mit einer Spannungs- oder Stromquelle verbunden ist, dieses Signal mittels des zweiten Widerstands (R₂) und des dritten Widerstands (R_{In}) am Signalabgriff (5) und/oder am Überwachungsabgriff (6) gemessen werden kann, wobei vorzugsweise hierfür auch auf den ersten Widerstand (R₁) zurückgegriffen werden kann.

9. Verfahren nach Anspruch 7 oder 8, wobei der zweite Schalter (S₂) hierbei geschlossen ist und/oder das Eingangssignal (2) ein analoges Signal ist.

10. Verfahren nach einem der vorhergehenden Ansprüche 7 - 9, wobei in dem Verfahren ferner:
bei geöffnetem zweiten Schalter (S₂) anhand des Spannungsabfalls über den dritten Widerstand (R_{In}) gemessen wird, wie hoch die Spannung des Eingangssignals (2) ist.

11. Verfahren nach einem der vorhergehenden Ansprüche 7 - 10, wobei in dem Verfahren ferner:
bei geschlossenem zweiten Schalter (S₂) anhand des Spannungsabfalls über den zweiten Widerstand (R2), der vorzugsweise ein Widerstand mit Mittelabgriff für den Überwachungsabgriff (6) ist, bestimmt wird, wie hoch die Stromstärke des Eingangssignals (2) ist.

## Claims

1. A device (1) for measuring the current and voltage of an input signal (2), comprising:
a first terminal (3) for connecting to a supply voltage (U_{Versorgung}),
an input line (4) for connecting to the input signal (2) to be measured,
a first resistor (R₁), one end of which branches off from the input line (4) and the other end of which is connected to a first switch (S₁) that connects the first terminal (3) directly to the first resistor (R₁) in a closed state,
a second resistor (R₂), one end of which branches off from the input line (4) and
the other end of which is connected to a second switch (S₂) that connects earth directly to the second resistor (R₂) in a closed state,
a third resistor (R_{In}), one end of which branches off from the input line (4) and
the other end of which is directly connected to earth, and
a signal tap (5) which branches off from the input line (4) for determining a current and/or voltage measurement value, wherein, moreover,
a third switch (T1) connecting the first terminal (3) and the input line (4) is provided for bypassing the first resistor (R1) and the first switch (S1) in order to check the functionality of the first resistor (R1), and/or
a fourth switch (T2) connecting the input line (4) and earth is provided for bypassing the third resistor (RIn) in order to check the functionality of the third resistor (RIn).

2. The device (1) according to claim 1, wherein the second resistor (R₂) is a resistor having a centre tap, from which a monitoring tap (6) for determining a current and/or voltage measurement value branches off.

3. The device (1) according to claim 2, wherein the monitoring tap (6) is designed to enable the current and/or voltage to be measured via a second dissimilar channel to the signal tap (5).

4. The device (1) according to one of the preceding claims, wherein the signal tap (5) and preferably also the monitoring tap (6) according to claim 2 or 3 each have a respective resistor (7, 8) through which the signal to be tapped is routed.

5. The device (1) according to one of the preceding claims, wherein a control unit is provided which is designed to actuate the first switch (S₁) and/or the second switch (S₂) in order to measure the current and/or voltage of the input signal (2) or to detect the presence of a current source or voltage source at the input signal (2), depending on a switch position of the first switch (S₁) and/or of the second switch (S₂).

6. The device (1) according to claim 5, wherein the control unit is connected to the signal tap (5) and preferably also to the monitoring tap (6) according to claim 2 or 3, in order to carry out an evaluation of the signals that are received.

7. A method for measuring the current and/or voltage of an input signal (2) using a device (1) according to one of the preceding claims, wherein in the method:
by closing the first switch (S₁), a check is made to determine whether the input signal (2) is connected to a voltage source or current source or not, wherein
if the input signal (2) is not connected to a voltage source or current source, a defined voltage or current value at the signal tap (5) is derived from the ratios of the first resistor (R₁) and the second resistor (R₂), wherein
by closing a switch (T1) bypassing the first resistor (R1) and the first switch (S2), a check is made to determine whether the first resistor (R1) is working correctly, and/or
by closing a switch (T2) bypassing the third resistor (RIn), a check is made to determine whether the third resistor (RIn) is working correctly.

8. The method according to claim 7, wherein when the input signal (2) is connected to a voltage source or current source, this signal can be measured at the signal tap (5) and/or at the monitoring tap (6) by means of the second resistor (R₂) and the third resistor (R_{In}), wherein preferably the first resistor (R₁) can also be used for this purpose.

9. The method according to claim 7 or 8, wherein the second switch (S₂) is closed in this case and/or the input signal (2) is an analogue signal.

10. The method according to one of the preceding claims 7 to 9, wherein in the method, moreover:
when the second switch (S₂) is open, the voltage drop across the third resistor (R_{In}) is used to measure the voltage of the input signal (2).

11. The method according to one of the preceding claims 7 to 10, wherein in the method, moreover:
when the second switch (S₂) is closed, the voltage drop across the second resistor (R2), which is preferably a resistor having a centre tap for the monitoring tap (6), is used to determine the current intensity of the input signal (2).

## Revendications

1. Dispositif (1) pour mesurer le courant et la tension d'un signal d'entrée (2), comprenant :
une première borne (3) pour la connexion à une tension d'alimentation (U_{Versorgung}),
une ligne d'entrée (4) pour la connexion au signal d'entrée (2) à mesurer,
une première résistance (R₁) dont l'une des extrémités part de la ligne d'entrée (4) et dont l'autre extrémité est connectée à un premier commutateur (S₁) qui, dans un état fermé, connecte directement la première borne (3) à la première résistance (R₁),
une deuxième résistance (R₂) dont l'une des extrémités part de la ligne d'entrée (4) et dont l'autre extrémité est connectée à un deuxième interrupteur (S₂) qui, dans un état fermé, connecte directement la terre à la deuxième résistance (R₂),
une troisième résistance (R_{In}), dont l'une des extrémités part de la ligne d'entrée (4) et dont l'autre extrémité est directement connectée à la terre, et
une prise de signal (5) partant de la ligne d'entrée (4) pour déterminer une valeur de mesure de courant et/ou de tension, en outre
un troisième commutateur (T1) connectant la première borne (3) et la ligne d'entrée (4) étant prévu pour ponter la première résistance (R1) et le premier commutateur (S1), afin de vérifier le bon fonctionnement de la première résistance (R1), et/ou
un quatrième commutateur (T2) connectant la ligne d'entrée (4) et la terre étant prévu pour ponter la troisième résistance (RIn) afin de vérifier le bon fonctionnement de la troisième résistance (RIn).

2. Dispositif (1) selon la revendication 1, dans lequel la deuxième résistance (R₂) est une résistance à prise centrale de laquelle part une prise de surveillance (6) pour déterminer une valeur de mesure de courant et/ou de tension.

3. Dispositif (1) selon la revendication 2, dans lequel la prise de surveillance (6) est conçue pour permettre une valeur de mesure de courant et/ou de tension sur un deuxième canal dissimilaire à la prise de signal (5).

4. Dispositif (1) selon l'une quelconque des revendications précédentes, dans lequel la prise de signal (5) et de préférence également la prise de surveillance (6) selon la revendication 2 ou 3 disposent d'une résistance respective (7, 8) par laquelle le signal à prélever est conduit.

5. Dispositif (1) selon l'une quelconque des revendications précédentes, dans lequel il est prévu une unité de commande qui est conçue pour actionner le premier commutateur (S₁) et/ou le deuxième commutateur (S₂) afin d'effectuer une mesure de courant et/ou de tension du signal d'entrée (2) ou de détecter la présence d'une source de courant ou de tension sur le signal d'entrée (2) en fonction d'une position de commutation du premier commutateur (S₁) et/ou du deuxième commutateur (S₂).

6. Dispositif (1) selon la revendication 5, dans lequel l'unité de commande est connectée à la prise de signal (5) et de préférence également à la prise de surveillance (6) selon la revendication 2 ou 3, afin de procéder à une évaluation des signaux reçus.

7. Procédé de mesure de courant et/ou de tension d'un signal d'entrée (2) avec un dispositif (1) selon l'une quelconque des revendications précédentes, dans lequel :
il est vérifié, en fermant le premier commutateur (S₁), si le signal d'entrée (2) est connecté ou non à une source de tension ou de courant,
si le signal d'entrée (2) n'est pas connecté à une source de tension ou de courant, une valeur de tension ou de courant définie est obtenue sur la prise de signal (5) à partir des rapports entre la première résistance (R₁) et la deuxième résistance (R₂),
la fermeture d'un commutateur (T1) pontant la première résistance (R1) et le premier commutateur (S1) permettant de vérifier si la première résistance (R1) fonctionne sans défaut, et/ou
la fermeture d'un commutateur (T2) pontant la troisième résistance (RIn) permettant de vérifier si la troisième résistance (RIn) fonctionne sans défaut.

8. Procédé selon la revendication 7, dans lequel, si le signal d'entrée (2) est connecté à une source de tension ou de courant, ce signal peut être mesuré au moyen de la deuxième résistance (R₂) et de la troisième résistance (R_{In}) sur la prise de signal (5) et/ou sur la prise de surveillance (6), de préférence en recourant également à la première résistance (R₁) à cet effet.

9. Procédé selon la revendication 7 ou 8, dans lequel le deuxième commutateur (S₂) est fermé et/ou le signal d'entrée (2) est un signal analogique.

10. Procédé selon l'une quelconque des revendications 7 à 9 précédentes, dans lequel en outre :
lorsque le deuxième commutateur (S₂) est ouvert, la tension du signal d'entrée (2) est mesurée à partir de la chute de tension sur la troisième résistance (Rln).

11. Procédé selon l'une quelconque des revendications précédentes 7 à 10, dans lequel en outre :
lorsque le deuxième interrupteur (S₂) est fermé, l'intensité du signal d'entrée (2) est déterminée à partir de la chute de tension sur la deuxième résistance (R2), qui est de préférence une résistance à prise centrale pour la prise de surveillance (6),.
